# EUROPEAN PATENT APPLICATION

(11) **EP 4 593 039 A1**
(43) Date of publication of application: **30.07.2025**
(21) Application number: 23867284.4
(22) Date of filing: 06.09.2023
(51) Int. Cl.: H01B 17/60, H01B 17/58, H05K 9/00, H01H 31/02

(54) **ANTI-INTERFERENCE STRUCTURE OF CAPACITIVE VOLTAGE-DIVIDING INSULATING CORE BODY, HIGH-VOLTAGE ELECTRIC APPLIANCE, AND ISOLATING SWITCH**

(30) Priority: 23.09.2022 CN 202211167061
(71) Applicant: Beijing Ruiheng Xinyuan Investment Co., Ltd, Beijing 101407 (CN)
(72) Inventor: WANG, Huan, Beijing 101407 (CN); ZHUO, Jingshui, Beijing 101407 (CN); WANG, Weigao, Beijing 101407 (CN); LIU, Zhaohui, Beijing 101407 (CN)
(74) Representative: Petraz, Gilberto Luigi
(86) International application number: PCT/CN2023/117172
(87) International publication number: WO 2024/060993

(57) **Abstract**

The present invention relates to an anti-interference structure of a capacitive voltage-dividing insulating core body, and a high-voltage electrical appliance and an isolating switch which adopt the insulating core body. The capacitive voltage-dividing insulating core body includes a plurality of voltage-sharing capacitive screens which are arranged in a first insulating core body and arranged alternately with insulating layers in a surrounding manner, and the plurality of voltage-sharing capacitive screens form a voltage-sharing capacitor; the voltage-sharing capacitor and a voltage-dividing capacitor are connected in series to form a capacitive voltage divider; a plurality of shielding capacitive screens which are arranged alternately with the insulating layers are arranged around at least part of the voltage-sharing capacitive screens; the plurality of shielding capacitive screens form a shielding anti-interference capacitor; and in a radial direction of the first insulating core body, a distance between the shielding capacitive screen located on the outer side and the voltage-sharing capacitive screen correspondingly surrounded by the shielding capacitive screen is greater than a distance between the shielding capacitive screen located on the inner side and the voltage-sharing capacitive screen correspondingly surrounded by the shielding capacitive screen. Therefore, the influence of the shielding capacitive screens absorbing interference signals on the voltage-sharing capacitive screens can be reduced, and external interference signals can be eliminated, thereby improving the accuracy of the collected signals.

## Description

### FIELD OF THE INVENTION

The present invention relates to the field of high-voltage electrical appliances, in particular to an anti-interference structure of a capacitive voltage-dividing insulating core body, a high-voltage electrical appliance and an isolation switch.

### BACKGROUND OF THE INVENTION

The existing high-voltage electrical appliance includes a bushing, a cable terminal, a voltage transformer, a current transformer, an isolation switch, a circuit breaker, a lightning arrester and an insulator, etc., which are insulation-protected by a capacitive insulating core body. A plurality of voltage-sharing capacitive screens which are arranged alternately with insulating layers in a surrounding manner are arranged in the insulating core body, and the plurality of voltage-sharing capacitive screens gradually divide and drop a high voltage into a ground potential to realize insulation protection. Voltage-dividing capacitive screens are also wound in the insulating core body. The voltage-sharing capacitive screens form a voltage-sharing capacitor C1, and the voltage-dividing capacitive screens form a voltage-dividing capacitor C2. The voltage-sharing capacitor C1 and the voltage-dividing capacitor C2 are connected in series to form a capacitive voltage divider, and further form a voltage transformer (this low-power-consumption voltage transformer is also called VT). This type of voltage transformer VT has low power consumption and high safety. However, there remains a problem that the sampling accuracy is not high enough due to its small capacitance and easy interference. In order to improve the sampling accuracy, shielding capacitive screens may also be wound in the insulating core body in the prior art. The shielding capacitive screens form a shielding capacitor C3 for shielding external interference signals. According to research findings, the structural layout of the shielding capacitor C3 needs to be further improved to improve the sampling accuracy.

### SUMMARY

An object of the present invention is to overcome the defects of the prior art, and provide an anti-interference structure of a capacitive voltage-dividing insulating core body which functions as a capacitive voltage divider and has high sampling accuracy, and a high-voltage electrical appliance that adopts the above-mentioned anti-interference structure.

In order to fulfill the above object, the present invention adopts the following technical solutions.

An anti-interference structure of a capacitive voltage-dividing insulating core body includes a plurality of voltage-sharing capacitive screens 101 which are arranged in a first insulating core body 10 and arranged alternately with insulating layers in a surrounding manner, and the plurality of voltage-sharing capacitive screens 101 form a voltage-sharing capacitor C1; the voltage-sharing capacitor C1 and the voltage-dividing capacitor C2 are connected in series to form a capacitive voltage divider; a plurality of shielding capacitive screens 103 which are arranged alternately with insulating layers are arranged around at least part of the voltage-sharing capacitive screens 101; the plurality of shielding capacitive screens 103 form a shielding anti-interference capacitor C3; and in a radial direction of the first insulating core body 10, a distance between the shielding capacitive screen 103 located on the outer side and the voltage-sharing capacitive screen 101 correspondingly surrounding the shielding capacitive screen 103 is greater than a distance between the shielding capacitive screen 103 located on the inner side and the voltage-sharing capacitive screen 101 correspondingly surrounding the shielding capacitive screen 103.

Preferably, in the radial direction of the first insulating core body 10, at least part of the shielding capacitive screens 103 from the inner side to the outer side deflect along an axial direction of the first insulating core body 10 from one end of the first insulating core body 10 to the other end of the first insulating core body 10; at least part of voltage-sharing capacitive screens 101 surrounded by at least part of shielding capacitive screens 103 from the inner side to the outer side deflect along the axial direction of the first insulating core body 10 from the other end of the first insulating core body 10 to one end of the first insulating core body 10; and a deflection direction of at least part of the shielding capacitive screens 103 is opposite to a deflection direction of at least part of the voltage-sharing capacitive screen 101 surrounded by at least part of the shielding capacitive screens 103, so that at least part of the shielding capacitive screens 103 and at least part of the voltage-sharing capacitive screens 101 surrounded by at least part of shielding capacitive screens 103 are in an inverted "V"-shape or "V"-shape.

Preferably, the voltage-sharing capacitor C1, the voltage-dividing capacitor C2 and the shielding anti-interference capacitor C3 are all arranged in the first insulating core body 10, and the voltage-dividing capacitor C2 is composed of the voltage-dividing capacitive screens 102 that are wound alternately with the insulating layers.

Preferably, the shielding anti-interference capacitor C3 is embedded in a shielding core body, and the shielding core body is sleeved outside the first insulating core body 10.

Preferably, the plurality of shielding capacitive screens 103 that form the shielding anti-interference capacitor C3 are wrapped outside the voltage-sharing capacitor C1 and the voltage-dividing capacitor C2.

Preferably, the voltage-dividing capacitor C2 composed of the voltage-dividing capacitive screens 102 is located on the outer side of the voltage-sharing capacitor C1, grounding capacitive screens are arranged outside the voltage-dividing capacitor C2, and the plurality of shielding capacitive screens 103 that form the shielding anti-interference capacitor C3 are wrapped outside the voltage-sharing capacitor C1 and the voltage-dividing capacitor C2; the outermost voltage-sharing capacitive screen 101 is a high-voltage capacitive screen that is connected to a high voltage, the innermost voltage-sharing capacitive screen 101 is connected to the voltage-dividing capacitor C2, the innermost shielding capacitive screen 103 among the plurality of shielding capacitive screens 103 is connected to a high voltage, and the outermost shielding capacitive screen 103 is connected to a ground potential; or, the innermost voltage-sharing capacitive screen 101 is connected to the high voltage, the outermost voltage-sharing capacitive screen 101 is connected to the voltage-dividing capacitor C2, the outermost shielding capacitive screen 103 among the plurality of shielding capacitive screens 103 is connected to the high voltage, and the innermost shielding capacitive screen 103 is connected to the ground potential.

Preferably, the voltage-sharing capacitive screens 101 in the first insulating core body 10 are divided into at least two groups; one group of voltage-sharing capacitive screens 101 are first voltage-sharing capacitive screens 101-1, and the plurality of first voltage-sharing capacitive screens 101-1 and the insulating layers are arranged alternately in a surrounding manner to form the voltage-sharing capacitor C1; the other group of voltage-sharing capacitive screens 101 are second voltage-sharing capacitive screens 101-2, and the plurality of second voltage-sharing capacitive screens 101-2 and the insulating layers are arranged alternately in a surrounding manner to form the second voltage-sharing capacitor C1'; and the plurality of shielding capacitive screens 103 that form the shielding anti-interference capacitor C3 surround the plurality of first voltage-sharing capacitive screens 101-1.

Preferably, the voltage-dividing capacitor C2 composed of the voltage-dividing capacitive screens 102 is located on the outer sides of the first voltage-sharing capacitive screens 101-1 and the second voltage-sharing capacitive screens 101-2; the innermost first voltage-sharing capacitive screen 101-1 and the innermost second voltage-sharing capacitive screen 101-2 are connected to the high voltage; a grounding capacitive screen is arranged outside the voltage-dividing capacitor C2; the plurality of shielding capacitive screens 103 are nested and insulated with each other in an axial direction of the first insulating core body 10, and wrapped outside the first voltage-sharing capacitor C1 and a part of voltage-dividing capacitive screens 102 close to the first voltage-sharing capacitive screens 101-1; and the outermost shielding capacitive screen 103 among the plurality of shielding capacitive screens 103 is connected to the high voltage, and the innermost shielding capacitive screen 103 is connected to the ground potential.

Preferably, the anti-interference structure further includes a second insulation information capacitive screen that forms an insulation information acquisition capacitor C4, wherein a third lead wire is drawn from the second insulation information capacitive screen for on-line monitoring of insulation information.

Preferably, the insulation information acquisition capacitor C4 is connected in series between the voltage-sharing capacitor C1 and the voltage-dividing capacitor C2, the voltage-sharing capacitor C1, the insulation information acquisition capacitor C4 and the voltage-dividing capacitor C2 which are connected in series are connected in parallel to the shielding anti-interference capacitor C3, and the third lead wire is drawn between the voltage-sharing capacitor C1 and the insulation information acquisition capacitor C4; or, both ends of the shielding anti-interference capacitor C3 and the insulation information acquisition capacitor C4 which are connected in series are connected in parallel to both ends of the voltage-sharing capacitor C1 and the voltage-dividing capacitor C2 which are connected in series, and the third lead wire is drawn between the shielding anti-interference capacitor C3 and the insulation information acquisition capacitor C4.

Preferably, in the axial direction of the first insulating core body 10, the overall length of a capacitive screen shield formed by the plurality of shielding capacitive screens 103 is greater than or equal to the overall length of the wrapped voltage-sharing capacitor C1.

The present invention further provides a high-voltage electrical appliance. The high-voltage electrical appliance includes the anti-interference structure of the insulating core body.

Preferably, the high-voltage electrical appliance is any one of a bushing, a cable terminal, a voltage transformer, a current transformer, an isolation switch, a circuit breaker, a lightning arrester and an insulator, etc.

The present invention further provides a preferred solution of a bushing. The bushing includes a first insulating core body 10 which is wrapped outside a conductive rod or a conductive pipe. A mounting flange 21 is fixedly arranged on the outer side in the middle of the first insulating core body 10. The mounting flange 21 divides the first insulating core body 10 into a first bushing part and a second bushing part. A plurality of capacitive screens which are arranged alternately with the insulating layers are arranged in the first insulating core body 10. The plurality of capacitive screens include a plurality of voltage-sharing capacitive screens 101 that form a voltage-sharing capacitor C1, voltage-dividing capacitive screens 102 that form a voltage-dividing capacitor C2 and a plurality of shielding capacitive screens 103 that form a shielding anti-interference capacitor C3. The voltage-sharing capacitor C1 and the voltage-dividing capacitor C2 are connected in series to form a capacitive voltage divider, which functions as a voltage transformer; the plurality of shielding capacitive screens 103 are arranged to surround at least part of the voltage-sharing capacitive screens 101; in a radial direction of the first insulating core body 10, at least part of the shielding capacitive screens 103 from the inner side to the outer side deflect along an axial direction of the first insulating core body 10 from one end of the first insulating core body 10 to the other end of the first insulating core body 10; at least part of the first voltage-sharing capacitive screens 101-1 from the inner side to the outer side deflect along the axial direction of the first insulating core body 10 from the other end of the first insulating core body 10 to one end of the first insulating core body 10; and a deflection direction of at least part of the shielding capacitive screens 103 is opposite to a deflection direction of at least part of the first voltage-sharing capacitive screens 101-1 surrounded by at least part of the shielding capacitive screens 103.

Preferably, the voltage-sharing capacitive screens 101 in the first insulating core body 10 are divided into at least two groups; one group of voltage-sharing capacitive screens 101 are first voltage-sharing capacitive screens 101-1, and the plurality of first voltage-sharing capacitive screens 101-1 and the insulating layers are arranged alternately in a surrounding manner to form the voltage-sharing capacitor C1; the voltage-sharing capacitor C1 corresponds to the first bushing part; the other group of voltage-sharing capacitive screens 101 are second voltage-sharing capacitive screens 101-2, and the plurality of second voltage-sharing capacitive screens 101-2 and the insulating layers are arranged alternately in a surrounding manner to form a second voltage-sharing capacitor C1'; the second voltage-sharing capacitor C1' corresponds to the second bushing part; and the plurality of shielding capacitive screens 103 that form the shielding anti-interference capacitor C3 surround the plurality of first voltage-sharing capacitive screens 101-1.

Preferably, the bushing is a bushing for electrical equipment, the second bushing part is used for insertion into the electrical equipment, the first bushing part is located outside the electrical equipment, and an insulating umbrella skirt 23 is sleeved outside the first busing part. In the radial direction of the first insulating core body 10, at least part of the shielding capacitive screens 103 from the inner side to the outer side deflect along the axial direction of the first insulating core body 10 from one end of the first bushing part close to the mounting flange 21 to the other end of the first bushing part; at least part of the first voltage-sharing capacitive screens 101-1 from the inner side to the outer side deflect along the axial direction of the first insulating core body 10 from the other end of the first bushing part to one end close to the mounting flange 21; and a deflection direction of at least part of the shielding capacitive screens 103 is opposite to a deflection direction of at least part of the first voltage-sharing capacitive screens 101-1 surrounded by at least part of the shielding capacitive screens 103; and in the radial direction of the first insulating core body 10, the plurality of second voltage-sharing capacitive screens 101-2 from the inner side to the outer side deflect from one end of the second bushing part that is used for connection to the electrical equipment to the other end close to the mounting flange 21.

The present invention further provides a preferred solution of a cable terminal. The cable terminal includes a first insulating core body 10. The first insulating core body 10 is wrapped outside a conductive rod or a conductive pipe. A stress cone 31 is also arranged in one end of a cavity of the first insulating core body 10. A plurality of capacitive screens which are arranged alternately with the insulating layers are arranged in the first insulating core body 10; the plurality of capacitive screens include a plurality of voltage-sharing capacitive screens 101 that form a voltage-sharing capacitor C1, voltage-dividing capacitive screens 102 that form a voltage-dividing capacitor C2 and a plurality of shielding capacitive screens 103 that form a shielding anti-interference capacitor C3; the voltage-sharing capacitor C1 and the voltage-dividing capacitor C2 are connected in series to form a capacitive voltage divider, which functions as a voltage transformer; the plurality of shielding capacitive screens 103 are arranged to at least surround a part of the voltage-sharing capacitive screens 101; in a radial direction of the first insulating core body 10, at least part of the shielding capacitive screens 103 from the inner side to the outer side deflect along an axial direction of the first insulating core body 10 from one end of the first insulating core body 10 to the other end of the first insulating core body 10; at least part of the first voltage-sharing capacitive screens 101-1 from the inner side to the outer side deflect along the axial direction of the first insulating core body 10 from the other end of the first insulating core body 10 to one end of the first insulating core body 10; and a deflection direction of at least part of the shielding capacitive screens 103 is opposite to a deflection direction of at least part of the first voltage-sharing capacitive screens 101-1 surrounded by at least part of the shielding capacitive screens 103.

Preferably, the voltage-sharing capacitive screens 101 in the first insulating core body 10 are divided into at least two groups; one group of voltage-sharing capacitive screens 101 are first voltage-sharing capacitive screens 101-1, and the plurality of first voltage-sharing capacitive screens 101-1 and the insulating layers are arranged alternately in a surrounding manner to form the voltage-sharing capacitor C1; the other group of voltage-sharing capacitive screens 101 are second voltage-sharing capacitive screens 101-2, and the plurality of second voltage-sharing capacitive screens 101-2 and the insulating layers are arranged alternately in a surrounding manner to form a second voltage-sharing capacitor C1'; in the axial direction of the first insulating core body 10, the second voltage-sharing capacitor C1' is close to the stress cone 31 relative to the voltage-sharing capacitor C1; and the plurality of shielding capacitive screens 103 that form the shielding anti-interference capacitor C3 surround the plurality of first voltage-sharing capacitive screens 101-1.

Preferably, in the radial direction of the first insulating core body 10, at least part of the shielding capacitive screens 103 from the inner side to the outer side gradually deflect along the axial direction of the first insulating core body 10 from one end close to the stress cone 31 to a direction away from the stress cone 31; the plurality of first voltage-sharing capacitive screens 101-1 from the inner side to the outer side gradually deflect along the axial direction of the first insulating core body 10 from a direction away from the stress cone 31 to a direction close to the stress cone 31; a deflection direction of the plurality of first voltage-sharing capacitive screens 101-1 is opposite to a deflection direction of the plurality of shielding capacitive screens 103; and the plurality of second voltage-sharing capacitive screens 101-2 gradually deflect from a direction away from the stress cone 31 to a direction close to the stress cone 31.

The present invention further provides a preferred embodiment of an isolation switch. The isolation switch includes at least one insulating pillar 50, wherein the insulating pillar 50 is a capacitive insulating pillar 59; the capacitive insulating pillar 59 includes a first insulating core body 10; a plurality of capacitive screens which are arranged alternately with the insulating layers are arranged in the first insulating core body 10; the plurality of capacitive screens include a plurality of voltage-sharing capacitive screens 101 that form a voltage-sharing capacitor C1, voltage-dividing capacitive screens 102 that form a voltage-dividing capacitor C2 and a plurality of shielding capacitive screens 103 that form a shielding anti-interference capacitor C3; the voltage-sharing capacitor C1 and the voltage-dividing capacitor C2 are connected in series to form a capacitive voltage divider, which functions as a voltage transformer; the plurality of shielding capacitive screens 103 are arranged to at least surround a part of the voltage-sharing capacitive screens 101; in a radial direction of the first insulating core body 10, at least part of the shielding capacitive screens 103 from the inner side to the outer side deflect along an axial direction of the first insulating core body 10 from one end of the first insulating core body 10 to the other end of the first insulating core body 10; at least part of the first voltage-sharing capacitive screens 101-1 from the inner side to the outer side deflect along the axial direction of the first insulating core body 10 from the other end of the first insulating core body 10 to one end of the first insulating core body 10; and a deflection direction of at least part of the shielding capacitive screens 103 is opposite to a deflection direction of at least part of the first voltage-sharing capacitive screens 101-1 surrounded by at least part of the shielding capacitive screens 103.

Preferably, the isolation switch includes at least two insulating pillars 50, wherein one insulating pillar 50 is a capacitive insulating pillar 59, and the other insulating pillar 50 is provided with a lightning arrester assembly inside.

Preferably, the insulating pillar 50 provided with the lightning arrester assembly includes a fourth insulating core body 61. A lightning arrester assembly 46 is arranged in a cavity of the fourth insulating core body 61. The lightning arrester assembly 46 includes a plurality of zinc oxide valve plates 461. The plurality of zinc oxide valve plates 461 are stacked in the cavity of the fourth insulating core body 61, and are electrically connected to a wiring terminal 22 on the insulating pillar 50 through a conductor.

Preferably, a plurality of fourth capacitive screens 62 which are arranged alternately with the insulating layers in a surrounding manner are arranged in the fourth insulating core body 61. The plurality of fourth capacitive screens 62 include fourth voltage-sharing capacitive screens that form a fourth voltage-sharing capacitor, and fourth voltage-dividing capacitive screens that form a fourth voltage-dividing capacitor. A lead wire for partial discharge detection is drawn from a junction at which the fourth voltage-sharing capacitor and the fourth voltage-dividing capacitor are connected in series.

According to the anti-interference structure of the capacitive voltage-dividing insulating core body in the present invention, in the radial direction of the first insulating core body, a distance between the shielding capacitive screen located on the outer side and the voltage-sharing capacitive screen correspondingly surrounded by this shielding capacitive screen is greater than a distance between the shielding capacitive screen located on the inner side and the voltage-sharing capacitive screen correspondingly surrounded by this shielding capacitive screen. Therefore, the influence of the shielding capacitive screen absorbing interference signals on the voltage-sharing capacitive screen can be reduced, such that the shielding capacitive screens can well shield the voltage-sharing capacitive screens, and external interference signals are eliminated, thereby improving the accuracy of the collected signals.

In addition, the high-voltage electrical appliance that adopts the anti-interference structure of the insulating core body includes a bushing, a cable terminal, a voltage transformer, a current transformer, an isolation switch, a circuit breaker, a lightning arrester and an insulator, etc., integrates the function of the voltage transformer, and achieves the advantages of low power consumption, small equipment size, low cost and high accuracy of the collected signals.

### BRIEF DESCRIPTION OF THE DRAWINGS

FIG. 1 is a schematic structural diagram of a voltage transformer in Embodiment 1, in which a part of sectional view of the voltage transformer is shown;
FIG. 2 is a schematic structural diagram of a bushing for electrical equipment in Embodiment 2, in which a part of sectional view of the bushing for the electrical equipment is shown;
FIG. 3 is an enlarged view of Part A in FIG. 2;
FIG. 4 is a schematic structural diagram of a cable terminal in Embodiment 3, in which a part of sectional view of the cable terminal is shown;
FIG. 5 is an enlarged view of Part B in FIG. 4;
FIG. 6 is a schematic structural diagram of an isolation switch in Embodiment 4, in which a part of sectional view of an insulating pillar is shown;
FIG. 7 is a schematic structural diagram of an isolation switch in Embodiment 5, in which a part of sectional view of an insulating pillar is shown;
FIG. 8 is an electrical schematic diagram among a voltage-sharing capacitor C1, a voltage-dividing capacitor C2 and a shielding anti-interference capacitor C3, which are composed of capacitive screens, in an insulating core body;
FIG. 9 is an electrical schematic diagram in Embodiment 1 among a voltage-sharing capacitor C1, a voltage-dividing capacitor C2 and a shielding anti-interference capacitor C3, which are composed of capacitive screens in an insulating core body, and an insulation information acquisition capacitor C4; and
FIG. 10 is an electrical schematic diagram in Embodiment 2 among a voltage-sharing capacitor C1, a voltage-dividing capacitor C2 and a shielding anti-interference capacitor C3, which are composed of capacitive screens in an insulating core body, and an insulation information acquisition capacitor C4.

### DETAILED DESCRIPTION

The specific implementation of an anti-interference structure of an insulating core body of the present invention will be further described below with reference to the embodiments given in accompanying diagrams. The anti-interference structure of the insulating core body of the present invention is not limited to the description of the following embodiments.

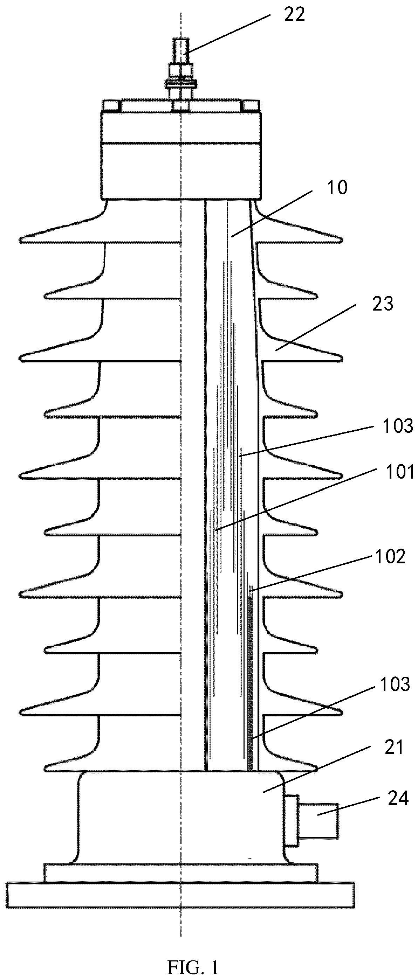

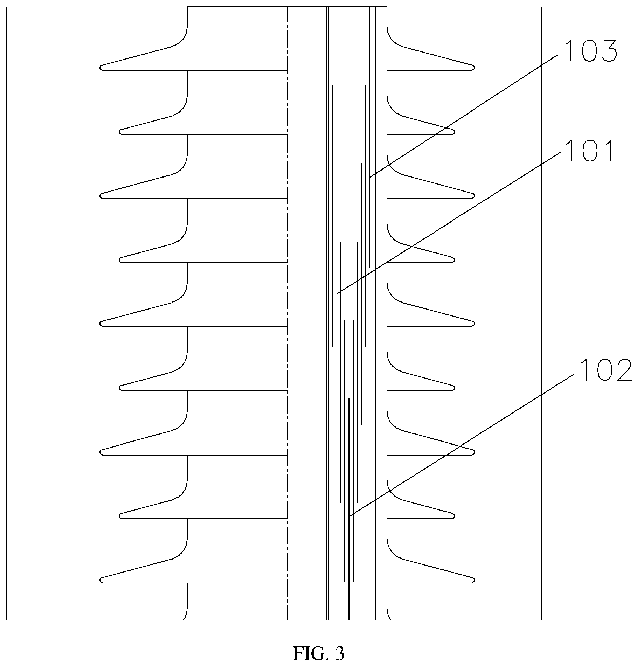

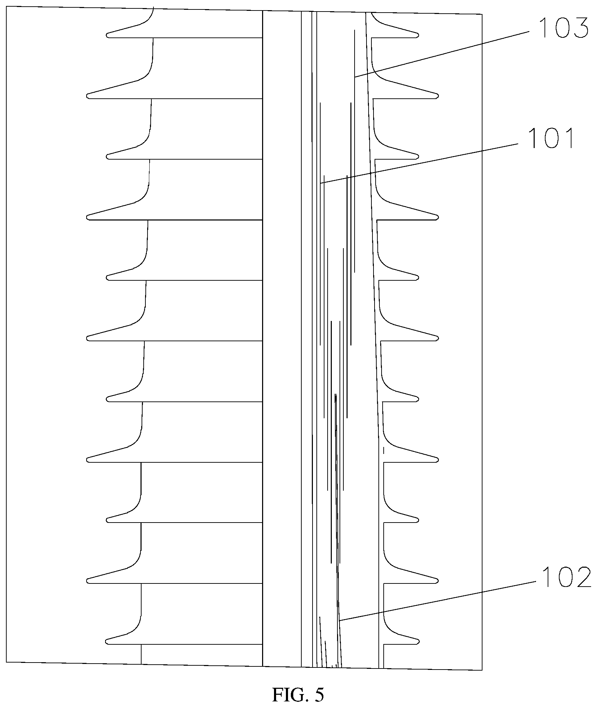

As shown in FIGs. 1-7, the present invention provides an anti-interference structure of a capacitive voltage-dividing insulating core body, which may be used for capacitive insulating core bodies of various high-voltage electrical appliances. The anti-interference structure of the insulating core body includes a plurality of voltage-sharing capacitive screens 101 which are arranged in a first insulating core body 10 and arranged alternately with insulating layers in a surrounding manner, and the plurality of voltage-sharing capacitive screens 101 form a voltage-sharing capacitor C1; the voltage-sharing capacitor C1 and the voltage-dividing capacitor C2 are connected in series to form a capacitive voltage divider which functions as a voltage transformer; a plurality of shielding capacitive screens 103 which are arranged alternately with insulating layers are arranged outside the plurality of voltage-sharing capacitive screens 101 in a surrounding manner; the plurality of shielding capacitive screens 103 form a shielding anti-interference capacitor C3; and in a radial direction of the first insulating core body 10, a distance between the shielding capacitive screen 103 located on the outer side and the voltage-sharing capacitive screen 101 correspondingly surrounded by the shielding capacitive screen 103 is greater than a distance between the shielding capacitive screen 103 located on the inner side and the voltage-sharing capacitive screen 101 correspondingly surrounded by the shielding capacitive screen 103. Therefore, the influence of the shielding capacitive screens 103 absorbing interference signals on the voltage-sharing capacitive screens 101 can be reduced, such that the shielding capacitive screens 103 can well shield the voltage-sharing capacitive screens 101, and external interference signals can be eliminated, thereby improving the accuracy of the collected signals.

According to Embodiment 1 shown in FIG. 1, Embodiment 1 is a voltage transformer. The voltage transformer includes a first insulating core body 10, wherein a mounting flange 21 is arranged at one end of the first insulating core body 10, and a wiring terminal 22 is arranged at the other end of the first insulating core body 10. A plurality of capacitive screens that are arranged alternately with insulating layers in a surrounding manner are arranged in the first insulating core body 10. An insulating umbrella skirt 23 is sleeved outside the first insulating core body 10. The plurality of capacitive screens include voltage-sharing capacitive screens 101, voltage-dividing capacitive screens 102 and shielding capacitive screens 103. The plurality of voltage-sharing capacitive screens 101 gradually divide and drop a high voltage into a low voltage to achieve insulation protection. The plurality of voltage-sharing capacitive screens 101 form a voltage-sharing capacitor C1. The voltage-dividing capacitive screens 102 are wound outside the voltage-sharing capacitive screens 101. The voltage-dividing capacitive screens 102 form a voltage-dividing capacitor C2. The voltage-sharing capacitor C1 and the voltage-dividing capacitor C2 are connected in series to form a capacitive voltage divider, which functions as a voltage transformer VT. A first lead wire is drawn between the voltage-sharing capacitor C1 and the voltage-dividing capacitor C2 to output collect signals. This capacitive voltage transformer has low or negligible power consumption. The plurality of shielding capacitive screens 103 are arranged at least to surround a part of the voltage-sharing capacitive screens 101, and the plurality of shielding capacitive screens 103 form a shielding anti-interference capacitor C3 for shielding external interference signals. As shown in FIG. 1, the plurality of shielding capacitive screens 103 in this embodiment are nested and insulated with each other in an axial direction of the first insulating core body 10 from one end of the first insulating core body 10 to the other end of the first insulating core body 10, and radially wrapped outside the voltage-sharing capacitor C1 and the voltage-dividing capacitor C2 to form a capacitive screen shield.

In particular, an improvement point of this embodiment lies in the layout arrangement of the capacitive screens in the first insulating core body 10. In a radial direction of the first insulating core body 10, at least part of the shielding capacitive screens 103 from the inner side to the outer side deflect along the axial direction of the first insulating core body 10 in sequence from one end of the first insulating core body 10 to the other end of the first insulating core body 10; at least part of the voltage-sharing capacitive screens 101 surrounded by at least part of the shielding capacitive screens 103 from the inner side to the outer side deflect along the axial direction of the first insulating core body 10 in sequence from the other end of the first insulating core body 10 to one end of the first insulating core body 10; and a deflection direction of at least part of the shielding capacitive screens 103 is opposite to a deflection direction of at least part of the voltage-sharing capacitive screens 101 surrounded by at least part of the shielding capacitive screens 103. The structural layout of such voltage-sharing capacitive screens 101 and shielding capacitive screens 103 makes the plurality of voltage-sharing capacitive screens 101 and the plurality of shielding capacitive screens 103 form an approximate inverted "V"-shape or a "V"-shape, so a distance between the shielding capacitive screen 103 in the radial direction of the first insulating core body 10 and the corresponding voltage-sharing capacitive screen 101 becomes farther and farther away. Therefore, the influence of the shielding capacitive screens 103 absorbing interference signals on the voltage-sharing capacitive screens 101 can be reduced, and the external interference signals can be eliminated, thereby improving the accuracy of the collected signals.

Specific referring to FIG. 1, from the inner side to the outer side of the first insulating core body 10, each voltage-sharing capacitive screen 101 gradually deflects relative to the adjacent voltage-sharing capacitive screen 101 on the inner side from the bottom end where a mounting flange 21 is arranged to the top end where a wiring terminal 22 is arranged. On a radial projection of the first insulating core body 10, the adjacent voltage-sharing capacitive screens 101 overlap at least partially. In the axial direction of the first insulating core body 10, among the two adjacent voltage-sharing capacitive screens 101, the voltage-sharing capacitive screen 101 on the inner side extends to a direction close to the bottom end relative to the voltage-sharing capacitive screen 101 on the outer side, and the voltage-sharing capacitive screen 101 on the outer side deflects and extends in a direction close to the top end relative to the voltage-sharing capacitive screen 101 on the inner side. However, in contrast, among the plurality of shielding capacitive screens 103, each shielding capacitive screen 103 gradually deflects from the top end where the wiring terminal 22 is arranged to the bottom end where the mounting flange 21 is arranged, relative to the adjacent shielding capacitive screen 103 on the inner side. On the radial projection of the first insulating core body 10, adjacent shielding capacitive screens 103 overlap at least partially. In the axial direction of the first insulating core body 10, among the two adjacent shielding capacitive screens 103, the shielding capacitive screen 3 on the inner side deflects and extends in a direction close to the top end relative to the shielding capacitive screen 103 on the outer side, and the shielding capacitive screen 103 on the outer side deflects and extends in a direction close to the bottom end relative to the shielding capacitive screen 103 on the inner side. **In** addition, the plurality of shielding capacitive screens 103 that form a shielding anti-interference capacitor C3 are wrapped outside the voltage-sharing capacitor C1 and the voltage-dividing capacitor C2. The plurality of voltage-sharing capacitive screens 101 and the plurality of shielding capacitive screens 103 form an approximate inverted "V"-shape or a herringbone shape in this embodiment, so a distance between the shielding capacitive screen 103 in the radial direction of the first insulating core body 10 and the corresponding voltage-sharing capacitive screen 101 becomes farther and farther away. Therefore, the influence of the shielding capacitive screens 103 absorbing interference signals on the voltage-sharing capacitive screens 101 can be reduced, and external interference signals can be eliminated, thereby improving the accuracy of the collected signals.

Preferably, in the axial direction of the first insulating core body 10, the overall length of the plurality of shielding capacitive screens 103 is not less than the overall length of the plurality of voltage-sharing capacitive screens 101. That is, the capacitive screen shield formed by the plurality of shielding capacitive screens 103 wraps the plurality of corresponding voltage-sharing capacitive screens 101. The length of a single shielding capacitive screen 103 may be greater than, equal to, or less than that of a single voltage-sharing capacitive screen 101, and the overall length of the capacitive screen shield is greater than or equal to the overall length of the wrapped voltage-sharing capacitor C1. Preferably, the capacitive screen shield can wrap all the voltage-sharing capacitive screens 101. Preferably, each voltage-sharing capacitive screen 101 in this embodiment is correspondingly provided with one shielding capacitive screen 103, and the length of each shielding capacitive screen 103 is not less than the length of the voltage-sharing capacitive screen 101 corresponding to this shielding capacitive screen 103. That is, the length of the shielding capacitive screen 103 is greater than or equal to the length of the corresponding voltage-sharing capacitive screen 101, and the shielding capacitive screen 103 wraps the corresponding voltage-sharing capacitive screen 101 on the radial projection of the first insulating core body 10. As a preferred embodiment, the length of each shielding capacitive screen 103 is equal to the length of the corresponding voltage-sharing capacitive screen 101, and the edges on both ends of the shielding capacitive screen 103 and the corresponding voltage-sharing capacitive screen 101 correspond each other on the radial projection of the first insulating core body 10. Preferably, each voltage-sharing capacitive screen 102 is also correspondingly provided with one shielding capacitive screen 103, and the length of the shielding capacitive screen 103 is not less than the length of the corresponding voltage-dividing capacitive screen 102. The shielding capacitive screen 103 wraps the corresponding voltage-sharing capacitive screen 102 on the radial projection of the first insulating core body 10.

It should be noted that, as other inferior embodiment, each of the shielding capacitive screens 103 may not be wrapped around the voltage-dividing capacitive screen 102 or only wrapped around a part of the voltage-dividing capacitive screen 102, or the shielding capacitive screen 103 may also be only wrapped around a part of the voltage-sharing capacitive screen 101. Of course, the accuracy of the collected signals will be affected. Moreover, the voltage-dividing capacitor C2 as a capacitor for voltage-dividing sampling may be arranged at other position within the first insulating core body 10.

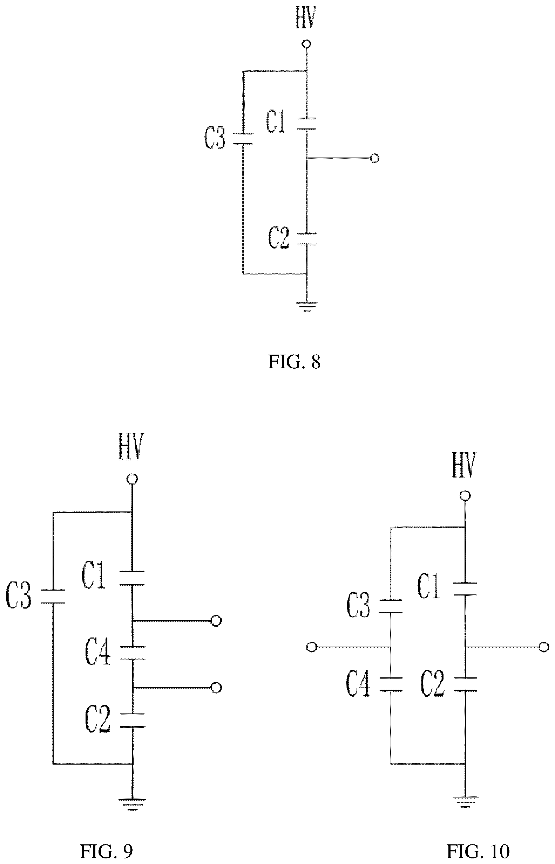

The first insulating core body 10 in this embodiment adopts glass fiber impregnated with epoxy resin as an insulating layer, and a semi-conductive tape or a metal strip as a capacitive screen. The insulating layers and the capacitive screens are arranged alternately on an insulating pillar in a surrounding manner to form a sleeve-shaped first insulating core body 10. Of course, other materials may also be used as the insulating layers and the capacitive screens. The first insulating core body 10 may also be a hollow insulating core body, that is, the insulating pillar may be removed, and other media may be filled or not filled as required. The plurality of capacitive screens, from the inner side to the outer side of the first insulating core body 10, are voltage-sharing capacitive screens 101, voltage-dividing capacitive screens 102 and grounding capacitive screens, respectively. The plurality of capacitive screens are arranged in a basically coaxial and concentric manner. The plurality of voltage-sharing capacitive screens 101 and the insulating layers are arranged alternately in a surrounding manner to form the voltage-sharing capacitor C1. The plurality of voltage-sharing capacitive screens 101 gradually divide a high voltage to play an insulating role. The outermost voltage-sharing capacitive screen 101 is a high-voltage capacitive screen, which is connected to a high voltage and electrically connected to the wiring terminal 22 in an equipotential manner. The innermost voltage-sharing capacitive screen 101 is connected to the voltage-dividing capacitor C2. The plurality of voltage-sharing capacitive screens 101 are nested and insulated with each other in the axial direction of the first insulating core body 10. The voltage-dividing capacitive screen 102 is located between the voltage-sharing capacitive screen 101 and the grounding capacitive screen. The voltage-dividing capacitor C2 composed of the voltage-dividing capacitive screens 102 is located on the outer side of the voltage-sharing capacitor C1. The grounding capacitive screens are arranged outside the voltage-dividing capacitor C2. The voltage-dividing capacitive screen 102 may be one or more. One voltage-dividing capacitive screen 102 and the grounding capacitive screens form the voltage-dividing capacitor C2 or a plurality of voltage-dividing capacitive screens 102 form the voltage-dividing capacitor C2. The voltage-sharing capacitor C1 and the voltage-dividing capacitor C2 are connected in series to form a capacitive voltage divider. A first lead wire is drawn between the voltage-sharing capacitor C1 and the voltage-dividing capacitor C2 as a signal source of the voltage transformer VT for achieving a voltage transformer function. The grounding capacitive screens are connected to the mounting flange 21 and then grounded. The plurality of shielding capacitive screens 103 are located between a high-voltage capacitive screen and a grounding capacitive screen. The plurality of shielding capacitive screens 103 are nested and insulated with each other in the axial direction of the first insulating core body 10 from one end of the first insulating core body 10 to the other end of the first insulating core body 10, and radially wrapped outside the first voltage-sharing capacitor C1 and the voltage-dividing capacitor C2 to shield external signal interferences. Among the plurality of shielding capacitive screens 103, the innermost shielding capacitive screen 103 is connected to the high voltage and equipotential to the wiring terminal 22; and the outermost shielding capacitive screen 103 is connected to a ground potential. Both ends of the shielding anti-interference capacitor C3 are connected in parallel to both ends of the voltage-sharing capacitor C1 and the voltage-dividing capacitor C2 which are connected in series, and used for shielding the interferences of external interference signals to a signal source collected by the capacitive voltage divider, thereby improving the signal acquisition accuracy. The outermost voltage-dividing capacitive screen 102, the outermost shielding capacitive screen 103 and the grounding capacitive screen may be one capacitive screen or a plurality of capacitive screens that are grounded separately. An electrical schematic diagram among the voltage-sharing capacitor C1, the voltage-dividing capacitor C2 and the shielding anti-interference capacitor C3 may refer to FIG. 8.

It should be noted that the voltage-sharing capacitor C1, the voltage-dividing capacitor C2 and the shielding anti-interference capacitor C3 in this embodiment are all arranged in the first insulating core body 10, which is a preferred embodiment of the present invention, with high reliability and convenience in assembly. However, as other embodiments, the voltage-sharing capacitor C1, the voltage-dividing capacitor C2 and the shielding anti-interference capacitor C3 may also be manufactured separately or in combination, and then assembled together, without being limited to overall production and split production, all of which belong to the protection scope of the present invention. For example, the voltage-sharing capacitor C1 and the voltage-dividing capacitor C2 may be manufactured in the first insulating core body 10 as a whole, the shielding anti-interference capacitor C3 may be manufactured in one independent shielding core body, the shielding capacitive screens 103 that form the shielding anti-interference capacitor C3 and the insulating layers are alternately embedded in the shielding core body, the shielding core body is then sleeved outside the first insulating core body 10, and the insulating umbrella skirt 23 is sleeved outside the shielding core body; or the voltage-sharing capacitor C1, the voltage-dividing capacitor C2 and the shielding anti-interference capacitor C3 are manufactured and then assembled separately, and the voltage-dividing capacitor C2 may also be implemented without winding the capacitive screens into the insulating core body, all of which belong to the protection scope of the present invention. Of course, the shielding capacitive screens 103 that form the shielding anti-interference capacitor C3 and the voltage-sharing capacitive screens 101 that form the voltage-sharing capacitor C1 still adopt the layout scheme in which the distance between the shielding capacitive screen 103 and the corresponding voltage-sharing capacitive screen 101 in the radial direction of the first insulating core body 10 becomes farther and farther away.

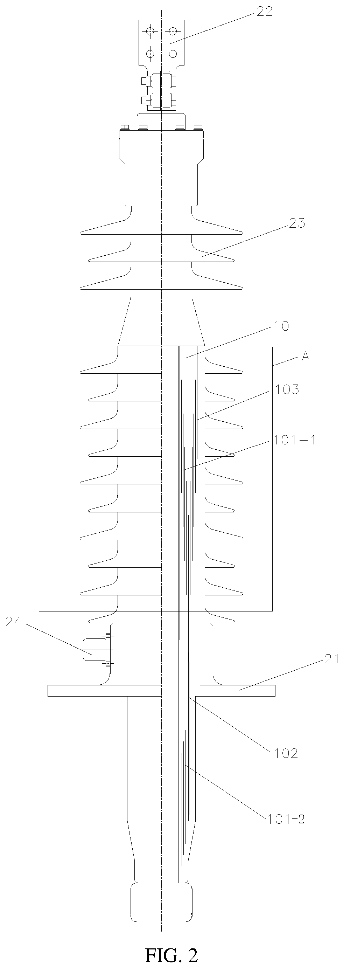

According to Embodiment 2 shown in FIGs. 2-3, Embodiment 2 is a bushing for electrical equipment. The bushing for electrical equipment in this embodiment includes a first insulating core body 10 that is wrapped outside a conductive rod or a conductive pipe. A mounting flange 21 is fixedly arranged on the outer side in the middle of the first insulating core body 10. The mounting flange 21 is used for fixed installation with the electrical equipment. The mounting flange 21 divides the first insulating core body 10 into a first bushing part located outside the electrical equipment and a second bushing part inserted into the electrical equipment. A pluggable contact may be arranged at an end of the second bushing part and in pluggable fit with the electrical equipment, and a wiring terminal 22, a voltage-sharing ring, etc., are arranged at an end of the first bushing part. The insulating umbrella skirt 23 is sleeved outside the first bushing part. For example, the bushing for the electrical equipment in this embodiment may installed with a transformer in a pluggable manner, which is of the prior art and will not be repeated.

A plurality of capacitive screens which are arranged alternately with the insulating layers are arranged in the first insulating core body 10. The plurality of capacitive screens include a plurality of voltage-sharing capacitive screens 101 that form the voltage-sharing capacitor C1, voltage-dividing capacitive screens 102 that form the voltage-dividing capacitor C2 and a plurality of shielding capacitive screens 103 that form the shielding anti-interference capacitor C3. The voltage-sharing capacitor C1 and the voltage-dividing capacitor C2 are connected in series to form a capacitive voltage divider, which functions as a voltage transformer. The plurality of shielding capacitive screens 103 are arranged to at least surround a part of the voltage-sharing capacitive screens 101. An improvement point of this embodiment lies in that: in a radial direction of the first insulating core body 10, at least part of the shielding capacitive screens 103 from the inner side to the outer side deflect along an axial direction of the first insulating core body 10 from one end of the first insulating core body 10 to the other end of the first insulating core body 10; at least part of first voltage-sharing capacitive screens 101-1 from the inner side to the outer side deflect along the axial direction of the first insulating core body 10 from the other end of the first insulating core body 10 to one end of the first insulating core body 10; and a deflection direction of at least part of the shielding capacitive screens 103 is opposite to a deflection direction of at least part of the first voltage-sharing capacitive screens 101-1 surrounded by at least part of the shielding capacitive screens 103.

Preferably, the voltage-sharing capacitive screens 101 in the first insulating core body 10 are divided into at least two groups. The voltage-sharing capacitive screens 101 in this embodiment may be divided into two groups, wherein one group of voltage-sharing capacitive screens 101 are first voltage-sharing capacitive screens 101-1, the plurality of first voltage-sharing capacitive screens 101-1 and the insulating layers are arranged alternately in a surrounding manner to form a voltage-sharing capacitor C1, the plurality of first voltage-sharing capacitive screens 101-1 gradually divide and drop a high voltage to a low voltage to achieve insulation protection, and the voltage-sharing capacitor C1 corresponds to the first bushing part; and the other group of voltage-sharing capacitive screens 101 are second voltage-sharing capacitive screens 101-2, the plurality of second voltage-sharing capacitive screens 101-2 and the insulating layers are arranged alternately in a surrounding manner to form a second voltage-sharing capacitor C1', the plurality of second shielding capacitive screens 101-2 gradually divide and drop a high voltage into a low voltage to achieve insulation protection, and the second voltage-sharing capacitor C1' corresponds to the second busing part. The voltage-dividing capacitive screens 102 are wound outside the voltage-sharing capacitive screens 101. The voltage-dividing capacitive screens 102 form a voltage-dividing capacitor C2. The voltage-sharing capacitor C1 and the voltage-dividing capacitor C2 are connected in series to form a capacitive voltage divider, which functions as a voltage transformer VT. A first lead wire is drawn between the voltage-sharing capacitor C1 and the voltage-dividing capacitor C2 to output collected signals. The plurality of shielding capacitive screens 103 are arranged around the plurality of first voltage-sharing capacitive screens 101-1, and the plurality of shielding capacitive screens 103 form a shielding anti-interference capacitor C3 for shielding external interference signals. The bushing for electrical equipment in this embodiment integrates a bushing function and a voltage transformer function. The product has small size, small occupied area, and low cost.

As shown in FIGs. 2-3, the plurality of shielding capacitive screens 103 in this embodiment are only wrapped around a part of voltage-sharing capacitive screens 101, that is, only wrapped around the first voltage-sharing capacitive screens 101-1, not wrapped around the second voltage-sharing capacitive screens 101-2, not wrapped around the voltage-dividing capacitive screens 102 or wrapped around a part of voltage-dividing capacitive screens 102. The plurality of shielding capacitive screens 103 in this embodiment are nested and insulated with each other in an axial direction of the first insulating core body 10 from one end of the first insulating core body 10 to the other end of the first insulating core body 10, and radially wrapped outside the voltage-sharing capacitor C1. In a radial direction of the first insulating core body 10, at least part of the shielding capacitive screens 103 from the inner side to the outer side deflect along an axial direction of the first insulating core body 10 from one end of the first insulating core body 10 to the other end of the first insulating core body 10; at least part of the first voltage-sharing capacitive screens 101-1 from the inner side to the outer side deflect along the axial direction of the first insulating core body 10 from the other end of the first insulating core body 10 to one end of the first insulating core body 10; and a deflection direction of at least part of the shielding capacitive screens 103 is opposite to a deflection direction of at least part of the first voltage-sharing capacitive screens 101-1 surrounded by at least part of the shielding capacitive screens 103, so that the plurality of first voltage-sharing capacitive screens 101-1 and the plurality of shielding capacitive screens 103 form an approximately "V"-shaped structure, and the distance between the shielding capacitive screen 103 and the corresponding first voltage-sharing capacitive screen 101-1 in the radial direction of the first insulating core body 10 becomes farther and farther way, thereby improving the accuracy of the collected signals.

Specifically, referring to FIGs. 2-3, the voltage-sharing capacitor C1 composed of the first voltage-sharing capacitive screens 101-1 and the shielding anti-interference capacitor C3 composed of the shielding capacitive screens 103 is located in the first bushing part of the first insulating core body 10. Form the inner side to the outer side of the first insulating core body 10, each shielding capacitive screen 103 gradually deflects from one end of the first bushing part close to the mounting flange 102 to the other end of the first bushing part that is provided with the wiring terminal 22, relative to the adjacent shielding capacitive screen 103 located on the inner side; each voltage-sharing capacitive screen 101-1 gradually deflects from the top end of the first bushing part where the wiring terminal 22 is arranged to one end close to the mounting flange 22, relative to the adjacent first voltage-sharing capacitive screen 101-1 located on the inner side; and the plurality of first voltage-sharing capacitive screens 101-1 are nested and insulated with each other along the axial direction of the first insulating core body 10. The second voltage-sharing capacitor C1' composed of the second voltage-sharing capacitive screens 101-2 is located in the second bushing part of the first insulating core body 10. Form the inner side to the outer side of the first insulating core body 10, each second voltage-sharing capacitive screen 101-2 gradually deflects from one end of the second bushing part connected to the electrical equipment to the other end close to the mounting flange 21, relative to the adjacent second voltage-sharing capacitive screen 101-2 located on the inner side; and the plurality of second voltage-sharing capacitive screens 101-2 are nested and insulated with each other along the axial direction of the first insulating core body 10. The voltage-dividing capacitive screens 102 that form the voltage-dividing capacitor C2 are arranged to correspond to the position of the mounting flange 21, extend into the first bushing part and the second bushing part, and are located outside the first voltage-sharing capacitive screens 101-1 and the second voltage-sharing capacitive screens 101-2. The mounting flange 21 is provided with a signal terminal 24, and a first lead wire is drawn between the voltage-sharing capacitor C1 and the voltage-dividing capacitor C2 to output a signal source from the signal terminal 24, and used for achieving a voltage transformer function. The innermost first voltage-sharing capacitive screen 101-1 and the second voltage-sharing capacitive screen 101-2 are high-voltage capacitive screens, connected to a high voltage, and electrically connected to the wiring terminal 22 in an equipotential manner. The innermost first voltage-sharing capacitive screen 101-1 and the second voltage-sharing capacitive screen 101-2 may share the same high-voltage capacitive screen, or are independent high-voltage capacitive screens, respectively. That is, in this embodiment, the innermost voltage-sharing capacitive screen 101 is connected to the high voltage, and the outermost voltage-sharing capacitive screen 101 is connected to the voltage-dividing capacitor C2; a grounding capacitive screen is arranged outside the voltage-dividing capacitor C2, and the grounding capacitive screen and the mounting flange 21 are connected and then grounded; the plurality of shielding capacitive screens 103 are nested and insulated with each other along the axial direction of the first insulating core body 10 from one end of the first bushing part close to the mounting flange 21 and the other end of the first bushing part, and radially wrapped outside the first voltage-sharing capacitor C1 and a part of the voltage-dividing capacitive screens 102 close to the first voltage-sharing capacitive screens 101-1; the outermost shielding capacitive screen 103 among the plurality of shielding capacitive screens 103 is connected to a high voltage and equipotential to the wiring terminal 22; the innermost shielding capacitive screen 103 is connected to a ground potential; and both ends of the shielding anti-interference capacitor C3 are connected in parallel to both ends of the voltage-sharing capacitor C1 and the voltage-dividing capacitor C2 which are connected in series.

The first insulating core body 10 in this embodiment adopts glass fiber impregnated with epoxy resin as the insulating layer, and a semi-conductive tape or a metal strip as the capacitive screen. The insulating layers and the capacitive screens are arranged alternately on the conductive rod in a surrounding manner to form the first insulating core body 10. The mounting flange 21 is fixedly mounted in the middle of the first insulating core body 10 to divide the first insulating core body 10 into a first bushing part located outside the electrical equipment and the second bushing part inserted into the electrical equipment. An insulating umbrella skirt 23 made of silicone rubber is sleeved outside the first bushing part.

As an embodiment of another bushing, e.g., a wall feed-through bushing (not shown), the wall feed-through bushing includes a first insulating core body 10 wrapped outside a conductive rod or a conductive pipe. A mounting flange 21 is fixedly arranged on the outer side in the middle of the first insulating core body 10. The mounting flange 21 divides the first insulating core body 10 into a first bushing part and the second bushing part, wherein the layout of the capacitive screens in the first bushing part may refer to the layout of the first bushing part in FIG. 2. That is, the first voltage-sharing capacitor C1 and the shielding anti-interference capacitor C3 are arranged in the first bushing part, and a distance between the shielding capacitive screen 103 located on the outer side and the first voltage-sharing capacitive screen 101-1 correspondingly surrounded by the shielding capacitive screen 103 is greater than a distance between the shielding capacitive screen 103 located on the inner side and the first voltage-sharing capacitive screen 101 correspondingly surrounded by the shielding capacitive screen 103. However, the layout of the capacitive screens in the second bushing part is similar to that in the first bushing part, both of which are axially symmetrical based on the position where the mounting flange 21 is located. That is, the second bushing part may be provided with a plurality of second voltage-sharing capacitive screens that form a second voltage-sharing capacitor C1' and a plurality of shielding capacitive screens 103 that form a shielding anti-interference capacitor C3'; the plurality of shielding capacitive screens 103 are wrapped around a plurality of second voltage-sharing capacitive screens 101-2, and a distance between the shielding capacitive screen 103 located on the outer side and the first voltage-sharing capacitive screen 101-2 correspondingly surrounded by the shielding capacitive screen 103 is greater than a distance between the shielding capacitive screen 103 located on the inner side and the first voltage-sharing capacitive screen 101-1 correspondingly surrounded by the shielding capacitive screen 103. Of course, it is also possible to not arrange the shielding anti-interference capacitor C3'. The voltage-dividing capacitive screens 102 that form the voltage-dividing capacitor C2 correspond to the position of the mounting flange 21, extend into the first bushing part and the second bushing part, and are located on the outer sides of the first voltage-sharing capacitive screens 101-1 and the second voltage-sharing capacitive screens 101-2. Of course, the voltage-dividing capacitor C2 may also be arranged at other positions in the first insulating core body 10, e.g., only correspondingly arranged in the first bushing part or in the second bushing part.

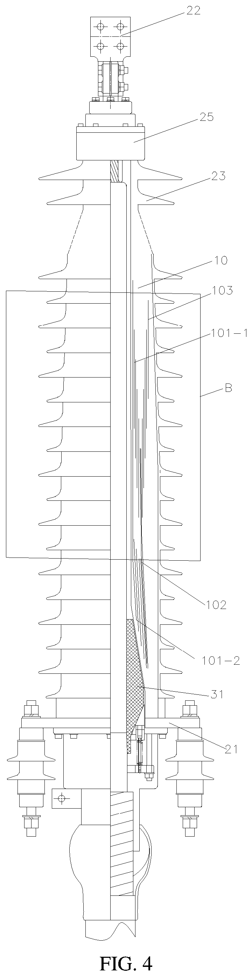

According to Embodiment 3 shown in FIGs. 4-5, Embodiment 3 is a cable terminal. The cable terminal of this embodiment includes a first insulating core body 10. A mounting flange 21 is arranged at one end of the first insulating core body 10, and an upper flange 25 and a wiring terminal 22 are arranged at the other end of the first insulating core body 10. The first insulating core body 10 is wrapped outside a conductive rod or a conductive pipe. A stress cone 31 is also arranged in one end of a cavity of the first insulating core body 10. The stress cone 31 is sleeved on a cable and closely press-fitted into the first insulating core body 10. An end of a lead core of the cable is fixedly and electrically connected to the conductive rod, or fixedly and electrically connected to the wiring terminal 22 through the conductive pipe. An insulating umbrella skirt 23 is sleeved outside the first insulating core body 10, which is of the prior art and will not be repeated.

A plurality of capacitive screens which are arranged alternately with the insulating layers in a surrounding manner are arranged in the first insulating core body 10. The plurality of capacitive screens include voltage-sharing capacitive screens 101, voltage-dividing capacitive screens 102 and shielding capacitive screens 103. The plurality of shielding capacitive screens 103 are arranged at least partially to surround a part of the voltage-sharing capacitive screens 101. In the radial direction of the first insulating core body 10, a distance between the shielding capacitive screen 103 located on the outer side and the voltage-sharing capacitive screen 101 correspondingly surrounded by the shielding capacitive screen 103 is greater than a distance between the shielding capacitive screen 103 located on the inner side and the voltage-sharing capacitive screen 101 correspondingly surrounded by the shielding capacitive screen 103.

The voltage-sharing capacitive screens 101 in the first insulating core body 10 are divided into at least two groups. In this embodiment, the voltage-sharing capacitive screens 101 in the first insulating core body 10 are divided into two groups. The two groups of voltage-sharing capacitive screens 101 are distributed along the axial direction of the first insulating core, wherein the first group is arranged relatively away from the stress cone 31 in the axial direction of the first insulating core body 10 and is located at one end away from the stress cone 31 in the middle section of the first insulating core body 10; and the second group is arranged close to one end where the stress cone 31 is arranged, and cooperates with the stress cone 31 to improve the electrical field intensity at the root of the cable. The first group of voltage-sharing capacitive screens 101 are first voltage-sharing capacitive screens 101-1, and the plurality of first voltage-sharing capacitive screens 101-1 are arranged alternately with the insulating layers to gradually divide and drop a high voltage into a low voltage, thereby achieving insulation protection. The plurality of first voltage-sharing capacitive screens 101-1 form the voltage-sharing capacitor C1, the second group of voltage-sharing capacitive screens 101 are second voltage-sharing capacitive screens 101-2, and the plurality of second voltage-sharing capacitive screens 101-2 are arranged alternately with the insulating layers to gradually divide and drop a high voltage into a low voltage, thereby achieving insulation protection. The plurality of second voltage-sharing capacitive screens 101-2 form a second voltage-sharing capacitor C1', each voltage-dividing capacitive screen 102 is wound outside the corresponding voltage-sharing capacitive screen 101, the voltage-dividing capacitive screens 102 form the voltage-dividing capacitor C2, and the voltage-sharing capacitor C1 and the voltage-dividing capacitor C2 are connected in series to form a capacitive voltage divider for achieving a voltage transformer VT function. A first lead wire is drawn between the voltage-sharing capacitor C1 and the voltage-dividing capacitor C2 to output collected signals. The second voltage-sharing capacitor C1' is close to the stress cone 31 relative to the voltage-sharing capacitor C1 in the axial direction of the first insulating core body 10. In this embodiment, the plurality of shielding capacitive screens 103 are arranged around the plurality of first voltage-sharing capacitive screens 101-1 to form the shielding anti-interference capacitor C3, which is used for shielding external interference signals.

As shown in FIGs. 4-5, the plurality of shielding capacitive screens 103 in this embodiment only are wrapped around a part of voltage-sharing capacitive screens 101, that is, only wrapped around the first voltage-sharing capacitive screens 101-1, not wrapped around the second voltage-sharing capacitive screens 101-2, not wrapped around the voltage-dividing capacitive screens 102 or wrapped around a part of voltage-dividing capacitive screens 102.

The plurality of shielding capacitive screens 103 in this embodiment are nested and insulated with each other in the axial direction of the first insulating core body 10 from one end of the first insulating core body 10 to the other end of the first insulating core body 10, and radially wrapped outside the voltage-sharing capacitor C1. In the radial direction of the first insulating core body 10, at least part of the shielding capacitive screens 103 from the inner side to the outer side deflect along the axial direction of the first insulating core body 10 from one end close to the stress cone 31 to a direction away from the stress cone 31. The plurality of first voltage-sharing capacitive screens 101-1 from the inner side to the outer side gradually deflect along the axial direction of the first insulating core body 10 from a direction away from the stress cone 31 to a direction close to the stress cone 31. The plurality of first voltage-sharing capacitive screens 101-1 are nested and insulated with each other along the axial direction of the first insulating core body 10. A deflection direction of the plurality of first voltage-sharing capacitive screens 101-1 is opposite to a deflection direction of the plurality of shielding capacitive screens 103, such that a distance between the shielding capacitive screen 103 and the corresponding first voltage-sharing capacitive screen 101-1 in the radial direction of the first insulating core body 10 becomes farther and farther away, thereby improving the accuracy of the collected signals.

In the radial direction of the first insulating core body 10, from the inner side to the outer side of the first insulating core body 10, the plurality of second voltage-sharing capacitive screens 101-2 gradually deflect in a direction away from the stress cone 31 to a direction close to the stress cone 31; and the plurality of voltage-sharing capacitive screens 101 are nested and insulated with each other along the axial direction of the first insulating core body 10. The voltage-dividing capacitor C2 composed of the voltage-dividing capacitive screens 102 is located on the outer sides of the first voltage-sharing capacitive screens 101-1 and the second voltage-sharing capacitive screens 101-2. The innermost first voltage-sharing capacitive screen 101-1 and the innermost second voltage-sharing capacitive screen 101-2 are high-voltage capacitive screens, connected to a high voltage, and electrically connected to the wiring terminal 22 in an equipotential manner. The outermost first voltage-sharing capacitive screen 101-1 and the outermost voltage-sharing capacitive screen 101-2 are connected to the voltage-dividing capacitor C2. A grounding capacitive screen is arranged outside the voltage-dividing capacitor C2. The grounding capacitive screen is connected to the mounting flange 21 and then grounded. The plurality of shielding capacitive screens 103 are nested and insulated with each other in an axial direction of the first insulating core body 10, and wrapped outside the first voltage-sharing capacitor C1 and a part of voltage-dividing capacitive screens 102 close to the first voltage-sharing capacitive screens 101-1 in the radial direction of the first insulating core body 10. The outermost shielding capacitive screen 103 among the plurality of shielding capacitive screens 103 is connected to a high voltage and equipotential to the wiring terminal 22, and the innermost shielding capacitive screen 103 is connected to a ground potential. Both ends of the shielding anti-interference capacitor C3 are connected in parallel to both ends of the voltage-sharing capacitor C1 and the voltage-dividing capacitor C2 which are connected in series.

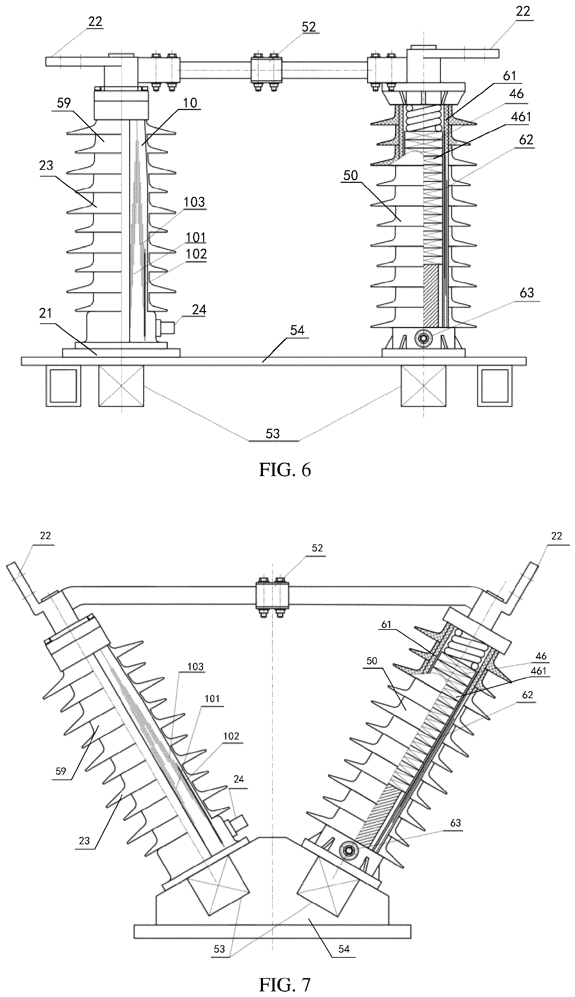

According to Embodiment 4 shown in FIG. 6, a high-voltage electrical appliance in Embodiment 4 is an isolation switch. The isolation switch in this embodiment includes two insulating pillars 50. Each insulating pillar 50 is provided with a static contact or a moving contact 52. Each of the insulating pillars 50 is provided with a wiring terminal 22. The wiring terminals 22 on the two insulating pillars 50 are electrically connected to the static contacts or moving contacts 52 on the corresponding insulating pillars 50. An insulating umbrella skirt 23 is sleeved outside each insulating pillar 50. The two insulating pillars 50 in this embodiment are vertically mounted on a support seat 54 at intervals. The two insulating pillars 50 are both provided with the moving contacts 52. Two rotary driving mechanisms 53 are mounted on the support seat 54 and respectively connected to the two insulating pillars 50. The two rotary driving mechanisms 53 can respectively drive the two insulating pillars 50 to rotate, so that the two moving contacts 52 are close to each other and contact to achieve a closing purpose, or away from each other to achieve an opening purpose. In this embodiment, the moving contacts 52 are mounted on the two insulating pillars 50, respectively. Obviously, as other embodiments, the static contact may also be mounted on one insulating pillar 50, and the moving contact 52 may be mounted on the other insulating pillar 50. The rotary driving mechanisms 53 drive the insulating pillars 50 that are provided with the moving contacts 52 to rotate, and drive the moving contacts 52 and the static contacts to cooperate for opening and closing purposes. As another embodiment, the isolation switch may further include a transmission pillar and two insulating pillars 50 that are vertically arranged on the support seat 54 at intervals, respectively. The transmission pillar is located between the two insulating pillars 50. Each of the two insulating pillars 50 is provided with a wiring terminal 22 and a static contact. The middle part of a moving contact conductive rod is mounted on the transmission pillar, and the moving contacts 52 are arranged at both ends of the moving contact conductive rod. The rotary driving mechanisms 53 drive the transmission pillar to rotate, and the transmission pillar drives the moving contact conductive rod to rotate, so that the moving contacts 52 at both ends of the moving contact conductive rod are in contact with and separated from the static contacts on the two insulating pillars 50 respectively, thereby achieving closing and opening purposes of the isolation switch, which is of the prior art and will not be repeated.

An improvement point in this embodiment lies in that: at least one of the two insulating pillars 50 is a capacitive insulating pillar 59; the capacitive type insulating pillar 59 includes a first insulating core body 10; a plurality of capacitive screens which are arranged alternately with the insulating layers are arranged in the first insulating core body 10; and the plurality of capacitive screens include voltage-sharing capacitive screens 101 that form a voltage-sharing capacitor C1, voltage-dividing capacitive screens 102 that form a voltage-dividing capacitor C2 and grounding capacitive screens, and the voltage-sharing capacitor C1 and the voltage-dividing capacitor C2 are connected in series to form a capacitive voltage divider, which is used for achieving a voltage transformer VT function. The plurality of capacitive screens further include a plurality of shielding capacitive screens 103 that form a shielding anti-interference capacitor C3. The plurality of shielding capacitive screens 103 are nested and insulated with each other in an axial direction of the first insulating core body 10 from one end of the first insulating core body 10 to the other end of the first insulating core body 10 and radially wrapped outside the voltage-sharing capacitor C1 and the voltage-dividing capacitor C2. In this embodiment, the capacitive voltage transformer is formed by the insulating pillars 50 of the isolation switch. This capacitive voltage transformer has low power consumption or negligible power consumption, so that an open-type combination electrical appliance using the isolation switch is adopted instead of an independent voltage transformer, thereby reducing the equipment size, the occupied area and the cost.

Specifically, a mounting flange 21 is arranged at one end of the capacitive insulating pillar 59, and the static contact or the moving contact 52 is mounted at the other end of the capacitive insulating pillar 59. The capacitive insulating pillar 59 may be mounted on a turntable of the support seat 54 through the mounting flange 21. The turntable is connected to the rotary driving mechanisms 53. A signal terminal 24 is arranged on the mounting flange 21. A second lead wire of the capacitive voltage divider in the first insulating core body 10 is drawn through the signal terminal 24. In the radial direction of the first insulating core body 10, the plurality of shielding capacitive screens 103 from the inner side to the outer side deflect along the axial direction of the first insulating core body 10 from one end of the first insulating core body 10 where the wiring terminal 22 is arranged to the other end of the first insulating core body 10 where the mounting flange 21 is arranged. At least part of voltage-sharing capacitive screens 101 surrounded by at least part of the shielding capacitive screens 103 from the inner side to the outer side deflect along the axial direction of the first insulating core body 10 from the other end of the first insulating core body 10 where the mounting flange 21 is arranged to one end of the first insulating core body 10 where the wiring terminal 22 is arranged. A deflection direction of the shielding capacitive screens 103 is opposite to a deflection direction of the voltage-sharing capacitive screens 101 surrounded by the shielding capacitive screens 103. The layout of the shielding capacitive screens 103 and the voltage-sharing capacitive screens 101 in this embodiment is similar to that of Embodiment 1, and will not be repeated in detail.

Optionally, a lightning arrester assembly may also be arranged in the first insulating core body 10. The lightning arrester assembly has a lightning arrester function and is further integrated with a lightning arrester, such that the open combination electrical appliance with the isolation switch may be adopted instead of an independent lightning arrester, thereby further reducing the equipment size, the occupied space and the cost. The scheme of integrating the lightning arrester assembly in the first insulating core body 10 may refer to the insulating pillar 50 on the right side.

Preferably, as shown in FIG. 6, the isolation switch in this embodiment includes two insulating pillars 50, wherein the insulating pillar 50 on the left side is a capacitive insulating pillar 59, the insulating pillar 50 on the right side is integrated with a lightning arrester, and the lightning arrester assembly 46 is arranged in the insulating pillar 50. The insulating pillar 50 includes a fourth insulating core body 61. A lightning arrester assembly 46 is arranged in a cavity of the fourth insulating core body 61. The lightning arrester assembly 46 includes a plurality of zinc oxide valve plates 461. The plurality of zinc oxide valve plates 461 are stacked in the cavity of the fourth insulating core body 61, and electrically connected to wiring terminals 22 on the insulating pillars 50 through conductors. In addition, an elastic member is arranged at the top of each zinc oxide valve plate 461 to be in closely press-fit with the zinc oxide valve plate 461. The fourth insulating core body 61 may be poured with epoxy resin, or may also be wound by glass fiber impregnated with epoxy resin. Preferably, a plurality of fourth capacitive screens 62 which are arranged alternately with the insulating layers in a surrounding manner are arranged in the fourth insulating core body 61. The fourth capacitive screens 62 can be used for insulated voltage-sharing, and can also be used for monitoring an external high-voltage system electrically connected to the isolation switch, e.g., for monitoring partial discharge of the electrical equipment. The plurality of fourth capacitive screens 62 include fourth voltage-sharing capacitive screens that form a fourth voltage-sharing capacitor, and fourth voltage-dividing capacitive screens that form a fourth voltage-dividing capacitor. A lead wire is drawn from a junction at which the fourth voltage-sharing capacitor and the fourth voltage-dividing capacitor are connected in series for partial discharge detection. A partial discharge monitoring terminal 63 is arranged on the mounting flange 21 of the insulating pillar 50 on the right side.

According to Embodiment 5 shown in FIG. 7, the isolation switch in this embodiment, similar to Embodiment 4, includes two insulating pillars 50, wherein the insulating pillar 50 on the left side is a capacitive insulating pillar 59, and the insulating pillar 50 on the right side is integrated with a lightning arrester assembly 46. Embodiment 5 differs from Embodiment 4 in that: the two insulating pillars 50 are obliquely arranged on the support seat 54, the top side of the support seat 54 is provided with two inclined planes that form an inverted V-shape, and the two insulating pillars 50 are respectively mounted on the two inclined planes to make the two insulating pillars 50 form an upright V-shape.

Referring to FIGs. 9-10, preferably, as another embodiment, an insulation information capacitive screen may also be arranged in the first insulating core body 10. That is, a plurality of capacitive screens in the first insulating core body 10 further include insulation information capacitive screens that form an insulation information acquisition capacitor C4. A second lead wire is drawn from the insulation information capacitive screen to realize on-line monitoring of insulation information of the insulating core body. A plurality of capacitive screens in the first insulating core body 10 form a voltage-sharing capacitor C1, a voltage-dividing capacitor C2, a shielding anti-interference capacitor C3 and an insulation information acquisition capacitor C4. The insulation information capacitive screens that form the insulation information acquisition capacitor C4 are wrapped between the voltage-sharing capacitor C1 and the voltage-dividing capacitor C2, the insulation information acquisition capacitor C4 is connected in series between the voltage-sharing capacitor C1 and the voltage-dividing capacitor C2, the voltage-sharing capacitor C1, the insulation information acquisition capacitor C4 and the voltage-dividing capacitor C2 which are connected in series are connected in parallel to the shielding anti-interference capacitor C3, and a second lead wire is drawn between the voltage-sharing capacitor C1 and the insulation information acquisition capacitor C4; or, the insulation information capacitive screens that form the insulation information acquisition capacitor C4 are wrapped outside the shielding anti-interference capacitor C3, both ends of the shielding anti-interference capacitor C3 and the insulation information acquisition capacitor C4 which are connected in series are connected in parallel to both ends of the voltage-sharing capacitor C1 and the voltage-dividing capacitor C2 which are connected in series, and a second lead wire is drawn between the shielding anti-interference capacitor C3 and the insulation information acquisition capacitor C4. The first insulating core body 10 in this embodiment may likewise be used for various high-voltage electrical appliances.

It should be noted that the anti-interference structure of the insulating core body of the present invention is not limited to the voltage transformer, the bushing, the cable terminal, the isolation switch and other high-voltage electrical appliances of the above embodiments, or may also be used for various high-voltage electrical appliances of other types such as circuit breakers, current transformers, lightning arresters and insulators.

The above content is a further detailed description of the present invention in conjunction with specific preferred embodiments, and it cannot be considered that the specific implementation of the present invention are limited to these descriptions. For those of ordinary skill in the technical field to which the present invention belongs, several simple deductions or substitutions can be made without departing from the concept of the present invention, which should be regarded as falling within the protection scope of the present invention.

## Claims

1. An anti-interference structure of a capacitive voltage-dividing insulating core body, comprising a plurality of voltage-sharing capacitive screens (101) which are arranged in a first insulating core body (10) and arranged alternately with insulating layers in a surrounding manner, wherein the plurality of voltage-sharing capacitive screens (101) form a voltage-sharing capacitor (C1); the voltage-sharing capacitor (C1) and a voltage-dividing capacitor (C2) are connected in series to form a capacitive voltage divider; a plurality of shielding capacitive screens (103) which are arranged alternately with the insulating layers are arranged around at least part of the voltage-sharing capacitive screens (101); the plurality of shielding capacitive screens (103) form a shielding anti-interference capacitor (C3); and in a radial direction of the first insulating core body (10), a distance between the shielding capacitive screen (103) located on the outer side and the voltage-sharing capacitive screen (101) correspondingly surrounded by the shielding capacitive screen (103) is greater than a distance between the shielding capacitive screen (103) located on the inner side and the voltage-sharing capacitive screen (101) correspondingly surrounded by the shielding capacitive screen (103).

2. The anti-interference structure of the capacitive voltage-dividing insulating core body according to claim 1, wherein in the radial direction of the first insulating core body (10), at least part of the shielding capacitive screens (103) from the inner side to the outer side deflect along an axial direction of the first insulating core body (10) from one end of the first insulating core body (10) to the other end of the first insulating core body (10); at least part of the voltage-sharing capacitive screens (101) surrounded by at least part of the shielding capacitive screens (103) from the inner side to the outer side deflect along the axial direction of the first insulating core body (10) from the other end of the first insulating core body (10) to one end of the first insulating core body (10); and a deflection direction of at least part of the shielding capacitive screens (103) is opposite to a deflection direction of at least part of the voltage-sharing capacitive screens (101) surrounded by at least part of the shielding capacitive screens (103), so that at least part of the shielding capacitive screens (103) and at least part of the voltage-sharing capacitive screens (101) surrounded by at least part of the shielding capacitive screens (103) are in an inverted "V"-shape or "V"-shape.

3. The anti-interference structure of the capacitive voltage-dividing insulating core body according to claim 1, wherein the voltage-sharing capacitor (C1), the voltage-dividing capacitor (C2) and the shielding anti-interference capacitor (C3) are all arranged in the first insulating core body (10), and the voltage-dividing capacitor (C2) is composed of voltage-dividing capacitive screens (102) that are alternately wound with the insulating layers.

4. The anti-interference structure of the capacitive voltage-dividing insulating core body according to claim 1, wherein the shielding anti-interference capacitor (C3) is embedded in a shielding core body, and the shielding core body is sleeved outside the first insulating core body (10).

5. The anti-interference structure of the capacitive voltage-dividing insulating core body according to claim 1, wherein the plurality of shielding capacitive screens (103) that form the shielding anti-interference capacitor (C3) are wrapped outside the voltage-sharing capacitor (C1) and the voltage-dividing capacitor (C2).

6. The anti-interference structure of the capacitive voltage-dividing insulating core body according to claim 3, wherein the voltage-dividing capacitor (C2) composed of the voltage-dividing capacitive screens (102) is located on the outer side of the voltage-sharing capacitor (C1), grounding capacitive screens are arranged outside the voltage-dividing capacitor (C2), and the plurality of shielding capacitive screens (103) that form the shielding anti-interference capacitor (C3) are wrapped outside the voltage-sharing capacitor (C1) and the voltage-dividing capacitor (C2); the outermost voltage-sharing capacitive screen (101) is a high-voltage capacitive screen connected to a high voltage, the innermost voltage-sharing capacitive screen (101) is connected to the voltage-dividing capacitor (C2), the innermost shielding capacitive screen (103) among the plurality of shielding capacitive screens (103) is connected to a high voltage, and the outermost shielding capacitive screen (103) is connected to a ground potential; or, the innermost voltage-sharing capacitive screen (101) is connected to the high voltage, the outermost voltage-sharing capacitive screen (101) is connected to the voltage-dividing capacitor (C2), the outermost shielding capacitive screen (103) among the plurality of shielding capacitive screens (103) is connected to the high voltage, and the innermost shielding capacitive screen (103) is connected to the ground potential.

7. The anti-interference structure of the capacitive voltage-dividing insulating core body according to claim 1, wherein the voltage-sharing capacitive screens (101) in the first insulating core body (10) are divided into at least two groups; one group of voltage-sharing capacitive screens (101) are first voltage-sharing capacitive screens (101-1), and the plurality of first voltage-sharing capacitive screens (101-1) and the insulating layers are arranged alternately in a surrounding manner to form the voltage-sharing capacitor (C1); the other group of voltage-sharing capacitive screens (101) are second voltage-sharing capacitive screens (101-2), and the plurality of second voltage-sharing capacitive screens (101-2) and the insulating layers are arranged alternately in a surrounding manner to form a second voltage-sharing capacitor (C1'); and the plurality of shielding capacitive screens (103) that form the shielding anti-interference capacitor (C3) surround the plurality of first voltage-sharing capacitive screens (101-1).

8. The anti-interference structure of the capacitive voltage-dividing insulating core body according to claim 7, wherein the voltage-dividing capacitor (C2) composed of the voltage-dividing capacitive screens (102) is located on the outer sides of the first voltage-sharing capacitive screens (101-1) and the second voltage-sharing capacitive screens (101-2); the innermost first voltage-sharing capacitive screen (101-1) and the innermost second voltage-sharing capacitive screen (101-2) are connected to the high voltage; a grounding capacitive screen is arranged outside the voltage-dividing capacitor (C2); the plurality of shielding capacitive screens (103) are nested and insulated with each other in an axial direction of the first insulating core body (10), and wrapped outside the first voltage-sharing capacitor (C1) and a part of voltage-dividing capacitive screens (102) close to the first voltage-sharing capacitive screens (101-1); and the outermost shielding capacitive screen (103) among the plurality of shielding capacitive screens (103) is connected to the high voltage, and the innermost shielding capacitive screen (103) is connected to a ground potential.

9. The anti-interference structure of the capacitive voltage-dividing insulating core body according to claim 1, further comprising: second insulation information capacitive screens that form an insulation information acquisition capacitor (C4), wherein a third lead wire is drawn from the second insulation information capacitive screen for on-line monitoring of insulation information.

10. The anti-interference structure of the capacitive voltage-dividing insulating core body according to claim 9, wherein the insulation information acquisition capacitor (C4) is connected in series between the voltage-sharing capacitor (C1) and the voltage-dividing capacitor (C2), the voltage-sharing capacitor (C1), the insulation information acquisition capacitor (C4) and the voltage-dividing capacitor (C2) which are connected in series are connected in parallel to the shielding anti-interference capacitor (C3), and the third lead wire is drawn between the voltage-sharing capacitor (C1) and the insulation information acquisition capacitor (C4); or, both ends of the shielding anti-interference capacitor (C3) and the insulation information acquisition capacitor (C4) which are connected in series are connected in parallel to both ends of the voltage-sharing capacitor (C1) and the voltage-dividing capacitor (C2) which are connected in series, and the third lead wire is drawn between the shielding anti-interference capacitor (C3) and the insulation information acquisition capacitor (C4).

11. The anti-interference structure of the capacitive voltage-dividing insulating core body according to claim 1, wherein in the axial direction of the first insulating core body (10), the overall length of a capacitive screen shield formed by the plurality of shielding capacitive screens (103) is greater than or equal to the overall length of the wrapped voltage-dividing capacitor (C1).

12. A high-voltage electrical appliance, comprising the anti-interference structure of the insulating core body according to any one of claims 1 to 11.

13. The high-voltage electrical appliance according to claim 12, wherein the high-voltage electrical appliance is any one of a bushing, a cable terminal, a voltage transformer, a current transformer, an isolation switch, a circuit breaker, a lightning arrester and an insulator.

14. An isolation switch, comprising at least one insulating pillar(50), wherein the at least one insulating pillar (50) is a capacitive insulating pillar (59); the capacitive insulating pillar (59) comprises a first insulating core body (10); a plurality of capacitive screens which are arranged alternately with the insulating layers are arranged in the first insulating core body (10); the plurality of capacitive screens comprise a plurality of voltage-sharing capacitive screens (101) that form a voltage-sharing capacitor (C1), voltage-dividing capacitive screens (102) that form a voltage-dividing capacitor (C2) and a plurality of shielding capacitive screens (103) that form a shielding anti-interference capacitor (C3); the voltage-sharing capacitor (C1) and the voltage-dividing capacitor (C2) are connected in series to form a capacitive voltage divider, which functions as a voltage transformer; the plurality of shielding capacitive screens (103) are arranged at least to surround at least part of the voltage-sharing capacitive screens (101); in a radial direction of the first insulating core body (10), at least part of the shielding capacitive screens (103) from the inner side to the outer side deflect along an axial direction of the first insulating core body (10) from one end of the first insulating core body (10) to the other end of the first insulating core body (10); at least part of the first voltage-sharing capacitive screens (101-1) from the inner side to the outer side deflect along the axial direction of the first insulating core body (10) from the other end of the first insulating core body (10) to one end of the first insulating core body (10); and a deflection direction of at least part of the shielding capacitive screens (103) is opposite to a deflection direction of at least part of the first voltage-sharing capacitive screens (101) surround by at least part of the shielding capacitive screens (103).

15. The isolation switch according to claim 14, comprising at least two insulating pillars (50), wherein one insulating pillar (50) is a capacitive insulating pillar (59), and the other insulating pillar (50) is provided with a lightning arrester assembly inside.
